# EUROPÄISCHE PATENTSCHRIFT

(11) **EP 2 837 275 B1**
(45) Veröffentlichungstag und Bekanntmachung des Hinweises auf die Patenterteilung: **10.05.2017**
(21) Anmeldenummer: 13721586.9
(22) Anmeldetag: 27.03.2013
(51) Int. Cl.: H05K 7/20

(54) **KÜHLGERÄT FÜR EINEN SCHALTSCHRANK SOWIE EIN ENTSPRECHENDES VERFAHREN**
COOLING DEVICE FOR A SWITCH CABINET AND A CORRESPONDING METHOD
APPAREIL DE REFROIDISSEMENT POUR ARMOIRE DE COMMANDE ET PROCÉDÉ CORRESPONDANT

(30) Priorität: 11.04.2012 DE 102012007089
(43) Veröffentlichungstag der Anmeldung: 18.02.2015
(73) Patentinhaber: RITTAL GmbH & Co. KG, 35745 Herborn (DE)
(72) Erfinder: CACHO ALONSO, Juan, Carlos, 35745 Herborn (DE)
(74) Vertreter: Angerhausen, Christoph
(86) Internationale Anmeldenummer: PCT/DE2013/000167
(87) Internationale Veröffentlichungsnummer: WO 2013/152749

(56) Entgegenhaltungen:
- DE-A1-102010 009 776
- DE-U1- 29 908 370

## Beschreibung

Die Erfindung betrifft ein Kühlgerät für einen Schaltschrank sowie ein entsprechendes Verfahren.

Ein gattungsgemäßes Kühlgerät ist beispielsweise aus der DE 10 2008 050 376 A1 bekannt. Das Kühlgerät weist einen Wärmetauscher auf, dem zwei räumlich getrennte Luftgänge zugeordnet sind, wobei der Wärmetauscher in einem Gehäuse untergebracht ist, das an den beiden einander gegenüberliegenden längsseitigen Enden Öffnungen aufweist, die jeweils einen Zugang zu einem der Luftgänge schaffen. Weitere Kühlgeräte sind aus der DE 299 08 370 U1 und DE 10 2010 009 776 A1 bekannt. Die gattungsgemäßen Kühlgeräte haben den Nachteil, dass sie insbesondere im Teillastbereich nicht energieeffizient arbeiten. Dies liegt daran, dass sie für maximale Effizienz bei maximaler Kühlleistung und somit im Teillastbereich im weniger effizienten An-Aus-Betrieb laufen.

Es ist daher die Aufgabe der Erfindung, ein gattungsgemäßes Kühlgerät für einen Schaltschrank sowie ein entsprechendes Verfahren zur Kühlung eines Schaltschrankes vorzuschlagen, welche eine energieeffiziente Kühlung des Schaltschrankinnenraums ermöglichen. Diese Aufgabe wird erfindungsgemäß durch ein Verfahren zur Kühlung eines Schaltschrankes nach dem Patentanspruch 1 sowie durch ein Kühlgerät für einen Schaltschrank nach dem Patentanspruch 4 gelöst. Die abhängigen Ansprüche betreffen jeweils bevorzugte Ausführungsformen der Erfindung.

Das erfindungsgemäße Kühlgerät umfasst ein Gehäuse, das einen ersten Luftgang zwischen einer ersten Lufteintrittsöffnung und einer ersten Luftaustrittsöffnung sowie einen zweiten Luftgang aufweist, der zwischen einer zweiten Lufteintrittsöffnung und einer zweiten Luftaustrittsöffnung ausgebildet ist. In dem ersten Luftgang ist ein Luft-Luft-Wärmetauscher angeordnet, wobei der Luft-Luft-Wärmetauscher weiterhin in dem zweiten Luftgang angeordnet ist. Die erste Lufteintrittsöffnung und die erste Luftaustrittsöffnung sind zur Umgebung des Schaltschrankes und die zweite Lufteintrittsöffnung sowie die zweite Luftaustrittsöffnung zum Innern des Schaltschrankes geöffnet, wobei der erste Luftgang von dem zweiten Luftgang fluidisch abgetrennt ist.

Die Verwendung eines Luft-Luft-Wärmetauschers zur Kühlung der durch den zweiten Luftgang geleiteten Luft aus dem Innern des Schaltschrankes wird dadurch möglich, dass in dem zweiten Luftgang in Luftströmungsrichtung hinter dem Luft-Luft-Wärmetauscher ein Luft-Wasser-Wärmetauscher und/oder ein Verdampfer angeordnet ist, der in Abhängigkeit der von dem Luft-Luft-Wärmetauscher erzeugten Vorkühlung eine bedarfsweise Nachkühlung der durch den zweiten Luftgang geleiteten Luft bereitstellt. Erfindungsgemäß ist der Luft-Wasser-Wärmetauscher und/oder Verdampfer ein kombinierter Luft-Wasser-Wärmetauscher und Verdampfer. Je nach geforderter Kühlleistung und Umgebungstemperatur des Schaltschrankes kann es somit zur Bereitstellung der notwendigen Nachkühlung hinreichend sein, dass zwischen dem Luft-Wasser-Wärmetauscher im zweiten Luftgang und einem entsprechenden Luft-Wasser-Wärmetauscher ein flüssiges Kühlmittel umgewälzt wird. Ist der Schaltschrank beispielsweise in einem Gebäude aufgestellt, kann das Kühlmittel zwischen dem Luft-Wasser-Wärmetauscher im zweiten Luftgang und einem weiteren Luft-Wasser-Wärmetauscher, welcher sich außerhalb des Gebäudes befindet und damit beispielsweise in den Wintermonaten eine Wärmesenke bildet, umgewälzt werden. In den Sommermonaten kann es notwendig sein, dass der kombinierte Luft-Wasser-Wärmetauscher und Verdampfer als Verdampfer eines kompressorangetriebenen Kühlkreislaufes betrieben wird. In diesem Fall wird dann das in dem Verdampfer verdampfte Kühlmittel verdichtet und in einem Verflüssiger, welcher in dem Gebäude oder bevorzugt außerhalb des Gebäudes aufgestellt ist, abgekühlt, um nach seiner Expansion in den Verdampfer im zweiten Luftgang für den Abtausch der Wärme der durch den zweiten Luftgang geleiteten Luft, geleitet zu werden.

Bei einer Ausführungsform der Erfindung ist vorgesehen, dass der Luft-Luft-Wärmetauscher in einen Durchlass zwischen dem ersten und zweiten Luftgang eingesetzt ist.

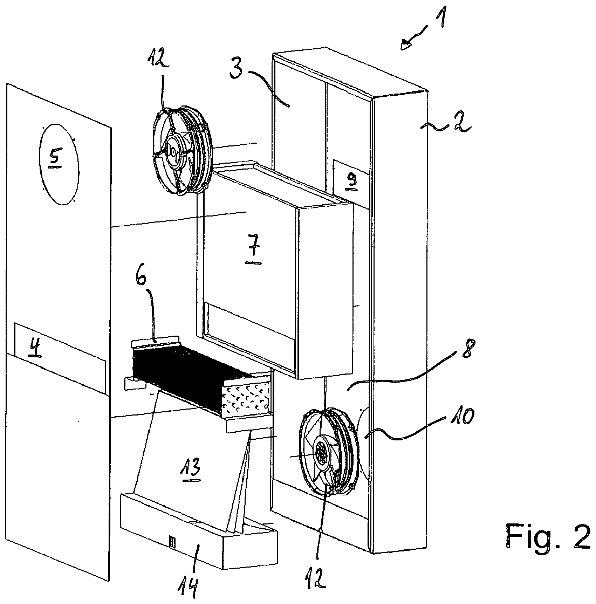

Bei einer anderen Ausführungsform der Erfindung ist vorgesehen, dass der Luft-Luft-Wärmetauscher den ersten Luftgang von dem zweiten Luftgang fluidisch abtrennt, wobei der erste und der zweite Luftgang über den Luft-Luft-Wärmetauscher für den Wärmeaustausch thermisch gekoppelt sind. Eine derartige Ausführungsform wird weiter unten mit Bezug auf die Figur 2 beschrieben.

Bei einer Ausführungsform der Erfindung ist vorgesehen, dass das Kühlgerät an einer Außeseite des Schaltschrankes montiert ist, wobei der erste Luftgang außerhalb des Schaltschrankes und der zweite Luftgang im Innern des Schaltschrankes angeordnet ist. Ebenso ist es wie von gattungsgemäßen Kühlgeräten bekannt auch bei dem erfindungsgemäßen Gerät denkbar, dass dieses vollständig außerhalb des Schaltschrankes angeordnet ist. Dabei kann die dem Schaltschrank zugewandte Außenseite des Kühlgerätes eine Begrenzungswand des zweiten Luftgangs sein, wobei in dieser Außenseite die zweite Lufteintrittsöffnung und die zweite Luftaustrittsöffnung ausgebildet sind. Erfindungsgemäß ist der Luft-Wasser-Wärmetauscher und/oder Verdampfer ein kombinierter Luft-Wasser-Wärmetauscher und Verdampfer, der Bestandteil eines wahlweise kompressorgetriebenen oder auf Umwälzung eines Kühlmittels basierenden Kühlkreislaufes ist, wobei der Kühlkreislauf weiterhin einen Kaltwassererzeuger, etwa einen kombinierten Luft-Wasser-Wärmetauscher und Verflüssiger aufweist, der einem anderen Wärmereservoir als der kombinierte Luft-Wasser-Wärmetauscher und Verdampfer zugeordnet ist. Beispielsweise kann der Schaltschrank innerhalb eines Gebäudes aufgestellt sein, wobei der Kaltwassererzeuger außerhalb des Gebäudes angeordnet ist.

Das erfindungsgemäße Verfahren zur Kühlung eines Schaltschrankes weist die folgenden Schritte auf:
- Durchleiten von Luft aus der Umgebung des Schaltschrankes durch einen ersten Luftgang eines Kühlgerätes;
- Durchleiten von Luft aus dem Innern des Schaltschrankes durch einen zweiten Luftgang des Kühlgerätes, wobei der erste und der zweite Luftgang fluidisch voneinander getrennt und über einen Luft-Luft-Wärmetauscher thermisch gekoppelt sind;
- Nachkühlen der durch den zweiten Luftgang durch den Luft-Luft-Wärmetauscher geleiteten Luft mit einem Luft-Wasser-Wärmetauscher und/oder einem Verdampfer.
Gemäß des erfindungsgemäßen Verfahrens ist der Luft-Wasser-Wärmetauscher und/oder Verdampfer ein kombinierter Luft-Wasser-Wärmetauscher und Verdampfer, der wahlweise als Luft-Wasser-Wärmetauscher oder als Verdampfer betrieben wird, wobei der kombinierte Luft-Wasser-Wärmetauscher und Verdampfer als Luft-Wasser-Wärmetauscher betrieben wird, wenn die von dem Luft-Wasser-Wärmetauscher bereitgestellte Nachkühlung der durch den zweiten Luftgang durch den Luft-Luft-Wärmetauscher geleiteten Luft ausreicht, um bei einer gegebenen Verlustleistung einer Wärmequelle im Innern des Schaltschrankes eine ausreichende Kühlung der durch den zweiten Luftgang geleiteten Luft zu erreichen. Der kombinierte Luft-Wasser-Wärmetauscher und Verdampfer wird als Verdampfer eines kompressorangetriebenen Kühlkreislaufes betrieben, wenn die bei dem Betrieb des kombinierten Luft-Wasser-Wärmetauscher und Verdampfers als Luft-Wasser-Wärmetauscher bereitgestellte Kühlleistung nicht ausreicht, um die Temperatur der in dem Schaltschrank aufgenommenen Luft auf einem gewünschten Niveau zu halten.

So kann es vorgesehen sein, dass der kombinierte Luft-Wasser-Wärmetauscher und Verdampfer für den Fall, dass die Kühlleistung des Luft-Wasser-Wärmetauschers nicht ausreicht, um eine Lufttemperatur im Innern des Schaltschrankes auf einer vorgegebenen Zieltemperatur zu halten, abwechselnd als Luft-Wasser-Wärmetauscher oder als Verdampfer betrieben wird. Dabei wird der kombinierte Luft-Wasser-Wärmetauscher und Verdampfer von dem Betrieb als Verdampfer auf den Betrieb als Luft-Wasser-Wärmetauscher umgestellt, wenn die Lufttemperatur im Innern des Schaltschrankes einen unteren Grenzwert, der unterhalb der Zieltemperatur liegt, erreicht, wobei der kombinierte Luft-Wasser-Wärmetauscher und Verdampfer von dem Betrieb als Luft-Wasser-Wärmetauscher auf den Betrieb als Verdampfer umgestellt wird, wenn die Lufttemperatur im Innern des Schaltschrankes einen oberen Grenzwert, der oberhalb der Zieltemperatur liegt, erreicht.

Bei einer Ausführungsform des erfindungsgemäßen Verfahrens ist vorgesehen, dass die Kühlleistung des Luft-Wasser-Wärmetauschers über eine Drehzahl einer das Kühlmittel umwälzenden Pumpe und/oder eine Drehzahl eines Ventilators eines weiteren Luft-Wasser-Wärmetauschers zwischen dem und dem Luft-Wasser-Wärmetauscher des kombinierten Luft-Wasser-Wärmetauschers und Verdampfers das Kühlmittel umgewälzt wird, geregelt wird. Ebenso kann für den Fall, dass der kombinierte Luft-Wasser-Wärmetauscher und Verdampfer die Funktion eines Verdampfers einnimmt, die Kühlleistung des Verdampfers über die Drehzahl eines Kompressors des kompressorgetriebenen Kühlkreislaufes geregelt werden.

Weitere Einzelheiten der Erfindung werden anhand der nachstehenden Figuren erläutert. Dabei zeigt
- Figur 1: eine schematische Darstellung des an einem Schaltschrank montierten erfindungsgemäßen Kühlgerätes; und
- Figur 2: eine Explosionsansicht der bevorzugten Ausführungsform des erfindungsgemäßen Kühlgerätes.

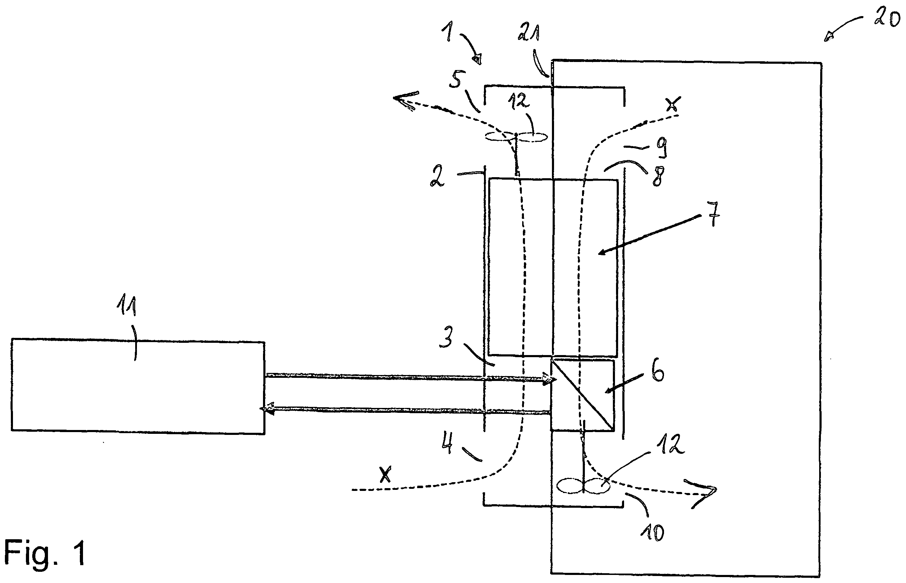

Die Figur 1 zeigt in schematischer Darstellung ein erfindungsgemäßes Kühlgerät 1, das an einer Außenseite 21 eines Schaltschrankes 20 montiert ist. Das Kühlgerät 1 umfasst ein Gehäuse 2, das einen ersten und einen zweiten Luftgang 3, 8 abgrenzt, wobei der erste Luftgang 3 zwischen einer ersten Lufteintrittsöffnung 4 und einer ersten Luftaustrittsöffnung 5 ausgebildet ist. Der zweite Luftgang 8 ist zwischen einer zweiten Lufteintrittsöffnung 9 und einer zweiten Luftaustrittsöffnung 10 ausgebildet. In dem ersten Luftgang 3 ist ein Luft-Luft-Wärmetauscher 7 angeordnet, welcher in den zweiten Luftgang 8 hineinragt und die Luftgänge 3, 8 thermisch koppelt. In dem zweiten Luftgang 8 ist in Luftströmungsrichtung x hinter dem Luft-Luft-Wärmetauscher 7 ein Luft-Wasser-Wärmetauscher und/oder Verdampfer 6 angeordnet. Der erste Luftgang 3 ist von dem zweiten Luftgang 8 fluidisch abgetrennt, wobei die erste Lufteintrittsöffnung 4 und die erste Luftaustrittsöffnung 5 zur Umgebung des Schaltschrankes 20 und die zweite Lufteintrittsöffnung 9 sowie die zweite Luftaustrittsöffnung 10 zum Innern des Schaltschrankes geöffnet sind. Es ist zu erkennen, dass der Luft-Luft-Wärmetauscher 7 durch einen Durchlass zwischen dem ersten und dem zweiten Luftgang 3, 8 hindurchragt, wobei der erste Luftgang 3 außerhalb des Schaltschrankes 20 und der zweite Luftgang 8 innerhalb des Schaltschrankes 20 angeordnet ist. Separate Lüfter 12 dienen dazu, die Umgebungsluft bzw. die in dem Schaltschrank 20 aufgenommene Luft durch den ersten Luftgang 3 bzw. den zweiten Luftgang 8 und damit jeweils durch den Luft-Luft-Wärmetauscher 7 zu treiben.

Ein Kaltwassererzeuger 11 ist einem anderen Wärmereservoir als der kombinierte Luft-Wasser-Wärmetauscher und Verdampfer 6 zugeordnet. Ist der Schaltschrank 20 beispielsweise in einem Gebäude aufgestellt, kann der Kaltwassererzeuger 11 beispielsweise auf dem Dach des Gebäudes oder an einer Außenwand des Gebäudes montiert sein. Im Winter kann der Kaltwassererzeuger 11 als Luft-Wasser-Wärmetauscher betrieben werden, wobei dieser aufgrund der niedrigen Außentemperaturen eine ausreichende Kühlung des Kühlmittels bereitstellt, welches zwischen diesem und dem kombinierten Luft-Wasser-Wärmetauscher und Verdampfer 6 im zweiten Luftgang 3 umgewälzt wird, damit über den Luft-Wasser-Wärmetauscher und Verdampfer 6 die durch den zweiten Luftgang 3 transportierte Umgebungsluft des Schaltschrankes 20 so weit runtergekühlt wird, dass einschließlich der Vorkühlung durch den Luft-Luft-Wärmetauscher 7 genügend Wärme aus dem Innern des Schaltschrankes 20 abgetauscht wird. Die aus dem Schaltschrankinnern über den Luft-Luft-Wärmetauscher 7 abgetauschte Wärme wird an die durch den ersten Luftgang 3 transportierte Luft übertragen und kann somit in den Wintermonaten zur Beheizung des Gebäudes bereitgestellt werden.

Andererseits ist die über die aus der ersten Luftaustrittsöffnung 5 austretende Luft an die Umgebung des Schaltschrankes 20 abgegebene Wärmemenge geringer als bei konventionellen Kühlgeräten, da ein Teil der aus dem Schaltschrankinneren abgetauschten Wärme über den Kaltwassererzeuger 11 außerhalb des Gebäudes freigesetzt wird. Dies führt dazu, dass durch die Verwendung des erfindungsgemäßen Kühlgerätes in den Sommermonaten die Umgebung des Schaltschrankes 20 nicht so stark erwärmt wird, wie bei Verwendung konventioneller Kühlgeräte.

Der Kühlkreislauf zwischen dem kombinierten Luft-Wasser-Wärmetauscher und Verdampfer 6 und dem Kaltwassererzeuger 11 kann zudem in einem Mischbetrieb Anwendung finden. Reicht beispielsweise die von dem kombinierten Luft-Wasser-Wärmetauscher und Verdampfer 6 bereitgestellte Vorkühlung nicht aus, um dauerhaft einschließlich des Luft-Luft-Wärmetauschers 7 eine ausreichende Kühlleistung bereitzustellen, ist jedoch die von dem kombinierten Luft-Wasser-Wärmetauscher und Verdampfer 6 bei Betrieb dieses als Verdampfer in einem kompressorangetriebenen Kühlkreislauf bereitgestellte Kühlleistung größer als es für eine ausreichende Nachkühlung der durch den zweiten Luftgang 8 transportierten Luft notwendig ist, kann der kombinierte Luft-Wasser-Wärmetauscher und Verdampfer 6 abwechselnd als Luft-Wasser-Wärmetauscher oder als Verdampfer und dementsprechend der Kühlkreislauf dieses abwechseln kompressorangetrieben oder lediglich unter Umwälzung eines Kühlmittels betrieben werden. Gegenüber dem konventionellen An-Aus-Betrieb eines kompressorgetriebenen Kühlkreislaufes können die zeitlichen Abstände zwischen dem Aussetzen des Kompressors und dem Wiedereinsetzen dieses verlängert und damit die Energieeffizienz des Gesamtsystems verbessert werden.

In Figur 2 ist die bevorzugte Ausführungsform der Erfindung dargestellt. Das Kühlgerät 1 weist wiederum einen ersten Luftgang 3 und einen zweiten Luftgang 8 auf, welche über den Luft-Luft-Wärmetauscher 7 fluidisch voneinander abgetrennt, jedoch thermisch gekoppelt sind. Das Gehäuse 2 des Kühlgeräts 1 weist an parallelen Seitenwänden die erste Lufteintrittsöffnung 4 sowie die erste Luftaustrittsöffnung 5 des ersten Luftgangs 3 bzw. die zweite Lufteintrittsöffnung 9 und die zweite Luftaustrittsöffnung 10 des zweiten Luftgangs 8 auf. Separate Lüfter 12 sind dazu bereitgestellt, die Umgebungsluft des Schaltschranks durch den ersten Luftgang 3 und die in dem Schaltschrank aufgenommene Luft durch den zweiten Luftgang 8 zu transportieren. Die durch den ersten Luftgang 3 und den zweiten Luftgang 8 transportierten Luftvolumina treten jeweils durch den Luft-Luft-Wärmetauscher fluidisch voneinander getrennt hindurch, wobei die transportierten Wärmemengen getauscht werden. Der kombinierte Luft-Wasser-Wärmetauscher und Verdampfer 6 ist in Luftströmungsrichtung in dem zweiten Luftgang 8 hinter dem Luft-Luft-Wärmetauscher 7 angeordnet. In dem kombinierten Luft-Wasser-Wärmetauscher und Verdampfer 6 kondensierende Luftfeuchtigkeit wird über einen Tröpfchenabscheider 13 in eine Kondensatwanne 14 abgeleitet. Das in der Figur 2 dargestellte Kühlgerät ist für die Außenmontage an einer Seitenwand eines Schaltschrankes vorgesehen, wobei der Schaltschrank an der entsprechenden Seitenwand mit den Öffnungen 9 und 10 korrespondierende Lufteintritts- und Luftaustrittsöffnungen aufweist. Da das Kühlgerät 1 somit vollständig außerhalb des Schaltschrankes 20 angeordnet ist, kann auch das in der Kondensatwanne 14 gesammelte Kondenswasser nicht mit dem Innenraum des Schaltschrankes 20 und den darin aufgenommenen Komponenten in Kontakt treten.

Wenn bei der vorliegenden Erfindung von einem Luft-Wasser-Wärmetauscher die Rede ist, so ist damit grundsätzlich jegliche Art von Wärmetauschern gemeint, bei denen über ein flüssiges Kühlmittel Wärme aus Luft abgetauscht oder Wärme an Luft übertragen werden kann. Das Kühlmittel ist insbesondere nicht auf Wasser beschränkt und soll insbesondere auch derartige Kühlmittel umfassen, wie sie in kompressorangetriebenen Kühlkreisläufen verwendet werden.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Kühlgerät
- 2: Gehäuse
- 3: erster Luftgang
- 4: erste Lufteintrittsöffnung
- 5: erste Luftaustrittsöffnung
- 6: Luft-Wasser-Wärmetauscher und/oder Verdampfer
- 7: Luft-Luft-Wärmetauscher
- 8: zweiter Luftgang
- 9: zweite Lufteintrittsöffnung
- 10: zweite Luftaustrittsöffnung
- 11: Kaltwassererzeuger
- 12: Lüfter
- 13: Tröpfchenabscheider
- 14: Kondensatwanne
- 20: Schaltschrank
- 21: Außenseite
- x: Luftströmungsrichtung

## Patentansprüche

1. Verfahren zur Kühlung eines Schaltschrankes (20), das die Schritte aufweist:
- Durchleiten von Luft aus der Umgebung des Schaltschrankes (20) durch einen ersten Luftgang (3) eines Kühlgerätes (1);
- Durchleiten von Luft aus dem Innern des Schaltschrankes (20) durch einen zweiten Luftgang (8) des Kühlgerätes (1), wobei der erste und der zweite Luftgang (3, 8) fluidisch voneinander getrennt und über einen Luft-Luft-Wärmetauscher (7) thermisch gekoppelt sind;
**gekennzeichnet durch**
- Nachkühlen der **durch** den zweiten Luftgang **durch** den Luft-Luft-Wärmetauscher (7) geleiteten Luft mit einem kombinierten Luft-Kühlmittel-Wärmetauscher und Verdampfer (6) in dem zweiten Luftgang (8), wobei der kombinierte Luft-Kühlmittel-Wärmetauscher und Verdampfer (6) Bestandteil eines wahlweise kompressorbetriebenen oder auf Umwälzung eines Kühlmittels basierenden Kühlkreislaufes ist, der weiterhin einen Luft-Kühlmittel-Wärmetauscher und Verflüssiger (11) aufweist, der außerhalb des Gehäuses einem anderen Wärmereservoir als der kombinierte Luft-Kühlmittel-Wärmetauscher und Verdampfer (6) zugeordnet ist,
wobei der kombinierte Luft-Kühlmittel-Wärmetauscher und Verdampfer (6) als Luft-Kühlmittel-Wärmetauscher betrieben wird, wenn die von dem Luft-Kühlmittel-Wärmetauscher bereitgestellte Nachkühlung der **durch** den zweiten Luftgang (8) **durch** den Luft-Luft-Wärmetauscher geleiteten Luft ausreicht, um bei einer gegebenen Verlustleistung einer Wärmequelle im Innern des Schaltschrankes (20) eine ausreichende Kühlung der **durch** den zweiten Luftgang (8) geleiteten Luft zu erreichen, und wobei der kombinierte Luft-Kühlmittel-Wärmetauscher und Verdampfer (6) als Verdampfer eines kompressorbetriebenen Kühlkreislaufes betrieben wird, wenn die bei dem Betrieb des kombinierten Luft-Kühlmittel-Wärmetauscher und Verdampfers (6) als Luft-Kühlmittel-Wärmetauscher bereitgestellte Kühlleistung nicht ausreicht.

2. Verfahren nach Anspruch 1, bei dem der kombinierte Luft-Kühlmittel-Wärmetauscher und Verdampfer (6) für den Fall, dass die Kühlleistung des Luft-Kühlmittel-Wärmetauschers nicht ausreicht, um eine Lufttemperatur im Innern des Schaltschrankes (20) auf einer vorgegebenen Zieltemperatur zu halten, der kombinierte Luft-Kühlmittel-Wärmetauscher und Verdampfer (6) abwechselnd als Luft-Kühlmittel-Wärmetauscher oder als Verdampfer betrieben wird, wobei der kombinierte Luft-Kühlmittel-Wärmetauscher und Verdampfer (6) von dem Betrieb als Verdampfer auf den Betrieb als Luft-Kühlmittel-Wärmetauscher umgestellt wird, wenn die Lufttemperatur im Innern des Schaltschrankes (20) einen unteren Grenzwert, der unterhalb der Zieltemperatur liegt, erreicht, und wobei der kombinierte Luft-Kühlmittel-Wärmetauscher und Verdampfer (6) von dem Betrieb als Luft-Kühlmittel-Wärmetauscher auf den Betrieb als Verdampfer umgestellt wird, wenn die Lufttemperatur im Innern des Schaltschrankes (20) einen oberen Grenzwert, der oberhalb der Zieltemperatur liegt, erreicht.

3. Verfahren nach einem der Ansprüche 1 oder 2, bei dem die Kühlleistung des Luft-Kühlmittel-Wärmetauschers über eine Drehzahl einer das Kühlmedium umwälzenden Pumpe und/oder eine Drehzahl eines Ventilators eines weiteren Luft-Kühlmittel-Wärmetauschers (12) zwischen dem und dem Luft-Kühlmittel-Wärmetauscher des kombinierten Luft-Kühlmittel-Wärmetauschers und Verdampfers das Kühlmittel umgewälzt wird, geregelt wird, und bei dem die Kühlleistung des Verdampfers über die Drehzahl eines Kompressors des kompressorbetriebenen Kühlkreislaufes geregelt wird.

4. Kühlgerät (1) für einen Schaltschrank (20), mit einem Gehäuse (2), das einen ersten Luftgang (3) mit einer ersten Lufteintrittsöffnung (4) und einer ersten Luftaustrittsöffnung (5) aufweist, wobei in dem ersten Luftgang (3) ein Luft-Luft-Wärmetauscher (7) angeordnet ist, und mit einem zweiten Luftgang (8), der zwischen einer zweiten Lufteintrittsöffnung (9) und einer zweiten Luftaustrittsöffnung (10) ausgebildet ist, wobei der Luft-Luft-Wärmetauscher (7) weiterhin in dem zweiten Luftgang (8) angeordnet ist, wobei die erste Lufteintrittsöffnung (4) und die erste Luftaustrittsöffnung (5) zur Umgebung des Schaltschrankes (20) und die zweite Lufteintrittsöffnung (9) sowie die zweite Luftaustrittsöffnung (10) zum Innern des Schaltschrankes (20) geöffnet sind, und wobei der erste Luftgang (3) von dem zweiten Luftgang (8) fluidisch abgetrennt ist,
**dadurch gekennzeichnet, dass** in Luftströmungsrichtung (x) hinter dem Luft-Luft-Wärmetauscher (7) ein kombinierter Luft-Kühlmittel-Wärmetauscher und Verdampfer (6), der wahlweise als Luft-Kühlmittel-Wärmetauscher oder als Verdampfer (6) betrieben ist, in dem zweiten Luftgang (8) angeordnet ist, der Bestandteil eines wahlweise kompressorbetriebenen oder auf Umwälzung eines Kühlmittels basierenden Kühlkreislaufes ist, der weiterhin einen Luft-Kühlmittel-Wärmetauscher und Verflüssiger (11) aufweist, der außerhalb des Gehäuses (2) einem anderen Wärmereservoir als der kombinierte Luft-Kühlmittel-Wärmetauscher und Verdampfer (6) zugeordnet ist, so dass der kombinierte Luft-Kühlmittel-Wärmetauscher und Verdampfer (6) als Luft-Kühlmittel-Wärmetauscher betrieben ist, wenn eine von dem Luft-Kühlmittel-Wärmetauscher bereitgestellte Nachkühlung der durch den zweiten Luftgang (8) durch den Luft-Luft-Wärmetauscher (7) geleiteten Luft ausreicht, um bei einer gegebenen Verlustleistung einer Wärmequelle im Innern des Schaltschrankes (20) eine ausreichende Kühlung der durch den zweiten Luftgang (8) geleiteten Luft zu erreichen, und so dass der kombinierte Luft-Kühlmittel-Wärmetauscher und Verdampfer (6) als Verdampfer eines kompressorbetriebenen Kühlkreislaufes betrieben ist, wenn die bei dem Betrieb des kombinierten Luft-Kühlmittel-Wärmetauscher und Verdampfers (6) als Luft-Kühlmittel-Wärmetauscher bereitgestellte Kühlleistung nicht ausreicht.

5. Kühlgerät (1) nach Anspruch 4, bei dem der Luft-Luft-Wärmetauscher (7) weiterhin in einen Durchlass zwischen dem ersten und dem zweiten Luftgang (3, 8) angeordnet ist.

6. Kühlgerät (1) nach Anspruch 4 oder 5, bei dem der Luft-Luft-Wärmetauscher (7) den ersten Luftgang (3) von dem zweiten Luftgang (8) fluidisch abtrennt, wobei der erste und der zweite Luftgang (3, 8) über den Luft-Luft-Wärmetauscher (7) für den Wärmeaustausch thermisch gekoppelt sind.

7. Kühlgerät (1) nach einem der Ansprüche 4 bis 6, bei dem das Kühlgerät (1) an einer Außenseite (21) des Schaltschrankes (20) montiert ist, wobei der erste Luftgang (3) außerhalb des Schaltschranks (20) und der zweite Luftgang (8) im Innern des Schaltschranks (20) angeordnet ist.

8. Kühlgerät (1) nach Anspruch 4, bei dem der Schaltschrank (20) innerhalb eines Gebäudes aufgestellt ist, wobei der Kaltwassererzeuger (11) außerhalb des Gebäudes angeordnet ist.

## Claims

1. A method for cooling a switch cabinet (20), comprising the following steps:
- passing air from the surroundings of the switch cabinet (20) through a first air duct (3) of a cooling device (1);
- passing air from the interior of the switch cabinet (20) through a second air duct (8) of the cooling device (1), the first air duct and the second air duct (3, 8) being fluidically separate from one another and being thermally coupled via an air-air heat exchanger (7);
**characterized by**
- aftercooling of the air, led through the second air duct via the air-air heat exchanger (7), using a combined air-coolant heat exchanger and evaporator (6) in the second air duct (8), the combined air-coolant heat exchanger and evaporator (6) being a component of a cooling circuit which is selectively compressor-driven or based on recirculation of a coolant, and which also has an air-coolant heat exchanger and a condenser (11), which outside the housing is associated with a different heat reservoir than the combined air-coolant heat exchanger and evaporator (6),
wherein the combined air-coolant heat exchanger and evaporator (6) is operated as an air-coolant heat exchanger when the after cooling of the air led through the second air duct (8) via the air-air heat exchanger, provided by the air-coolant heat exchanger, is sufficient, for a given loss in output of a heat source inside the switch cabinet (20), to achieve adequate cooling of the air led through the second air duct (8), and wherein the combined air-coolant heat exchanger and evaporator (6) is operated as an evaporator of a compressor-driven cooling circuit when the cooling power provided when the combined air-coolant heat exchanger and evaporator (6) is operated as an air-coolant heat exchanger is not sufficient.

2. The method according to Claim 1, wherein, for the case that the cooling power of the air-coolant heat exchanger is not sufficient to hold an air temperature inside the switch cabinet (20) at a predefined target temperature, the combined air-coolant heat exchanger and evaporator (6) is operated alternately as an air-coolant heat exchanger or as an evaporator, the combined air-coolant heat exchanger and evaporator (6) being switched from the operation as an evaporator to the operation as an air-coolant heat exchanger when the air temperature inside the switch cabinet (20) reaches a lower limit value that is below the target temperature, and the combined air-coolant heat exchanger and evaporator (6) being switched from the operation as an air-coolant heat exchanger to the operation as an evaporator when the air temperature inside the switch cabinet (20) reaches an upper limit value that is above the target temperature.

3. The method according to one of Claims 1 or 2, wherein the cooling power of the air-coolant heat exchanger is regulated via a rotational speed of a pump that recirculates the cooling medium, and/or via a rotational speed of a ventilator of a further air-coolant heat exchanger (12), the coolant being recirculated between the further air-coolant heat exchanger and the air-coolant heat exchanger of the combined air-coolant heat exchanger and evaporator, and wherein the cooling power of the evaporator is regulated via the rotational speed of a compressor of the compressor-driven cooling circuit.

4. A cooling device (1) for a switch cabinet (20), having a housing (2) that includes a first air duct (3) with a first air inlet opening (4) and a first air outlet opening (5), an air-air heat exchanger (7) being situated in the first air duct (3), and with a second air duct (8) that is provided between a second air inlet opening (9) and a second air outlet opening (10), the air-air heat exchanger (7) also being situated in the second air duct (8), the first air inlet opening (4) and the first air outlet opening (5) being open with respect to the surroundings of the switch cabinet (20), and the second air inlet opening (9) and the second air outlet opening (10) being open with respect to the interior of the switch cabinet (20), and the first air duct (3) being fluidically separate from the second air duct (8),
**characterized in that**, in the air flow direction (x) downstream from the air-air heat exchanger (7), a combined air-coolant heat exchanger and evaporator (6) that is selectively operated as an air-coolant heat exchanger or as an evaporator (6) is situated in the second air duct (8), which is a component of a cooling circuit which is selectively compressor-driven or based on recirculation of a coolant, and which also has an air-coolant heat exchanger and a condenser (11), which outside the housing (2) is associated with a different heat reservoir than the combined air-coolant heat exchanger and evaporator (6), so that the combined air-coolant heat exchanger and evaporator (6) is operated as an air-coolant heat exchanger when aftercooling of the air led through the second air duct (8) via the air-air heat exchanger (7), provided by the air-coolant heat exchanger, is sufficient, for a given loss in output of a heat source inside the switch cabinet (20), to achieve adequate cooling of the air led through the second air duct (8), and so that the combined air-coolant heat exchanger and evaporator (6) is operated as an evaporator.of a compressor-driven cooling circuit when the cooling power provided when the combined air-coolant heat exchanger and evaporator (6) is operated as an air-coolant heat exchanger is not sufficient.

5. The cooling device (1) according to Claim 4, in which the air-air heat exchanger (7) is also situated in a passage between the first second air duct and the second air duct (3, 8).

6. The cooling device (1) according to Claim 4 or 5, in which the air-air heat exchanger (7) fluidically separates the first air duct (3) from the second air duct (8), the first air duct and the second air duct (3, 8) being thermally coupled via the air-air heat exchanger (7) for the heat exchange.

7. The cooling device (1) according to one of Claims 4 to 6, in which the cooling device (1) is mounted on an outer side (21) of the switch cabinet (20), the first air duct (3) being situated outside the switch cabinet (20), and the second air duct (8) being situated inside the switch cabinet (20).

8. The cooling device (1) according to Claim 4, in which the switch cabinet (20) is set up inside a building, the chilled water generator (11) being situated outside the building.

## Revendications

1. Procédé pour le refroidissement d'une armoire de commande (20) qui comprend les étapes suivantes :
- guidage de l'air provenant de l'environnement de l'armoire de commande (20) à travers un premier passage d'air (3) d'un appareil de refroidissement (1) ;
- guidage de l'air de l'intérieur de l'armoire de commande (20) à travers un deuxième passage d'air (8) de l'appareil (1), le premier et le deuxième passage (3, 8) étant séparés de manière fluidique l'un de l'autre et étant couplés thermiquement par l'intermédiaire d'un échangeur de chaleur air-air (7) ;
**caractérisé par**
- un post-refroidissement de l'air guidé à travers le deuxième passage d'air par l'échangeur de chaleur air-air (7) avec un échangeur de chaleur air-fluide de refroidissement et évaporateur (6) combiné dans le deuxième passage d'air (8), l'échangeur de chaleur air-fluide de refroidissement et évaporateur (6) combiné faisant partie d'un circuit de refroidissement soit actionné par un compresseur soit basé sur la circulation d'un fluide de refroidissement et un condenseur (11), qui correspond, à l'extérieur du boîtier, à un réservoir de chaleur différent de l'échangeur de chaleur air-fluide de refroidissement et évaporateur (6) combiné,
l'échangeur de chaleur air-fluide de refroidissement et évaporateur (6) combiné fonctionne en tant qu'échangeur de chaleur air-fluide de refroidissement lorsque le post-refroidissement, créé par l'échangeur de chaleur air-fluide de refroidissement, de l'air guidé par le deuxième passage d'air (8) à travers l'échangeur de chaleur air-air suffit pour obtenir, lors d'une puissance de perte donnée d'une source de chaleur à l'intérieur de l'armoire de commande (20), un refroidissement suffisant de l'air guidé à travers le deuxième passage d'air (8) et l'échangeur de chaleur air-fluide de refroidissement et évaporateur (6) combiné fonctionne en tant qu'évaporateur d'un circuit de refroidissement actionné par un compresseur, lorsque la puissance de refroidissement mise à disposition lors du fonctionnement de l'échangeur de chaleur air-fluide de refroidissement et évaporateur (6) combiné en tant qu'échangeur de chaleur air-fluide de refroidissement n'est pas suffisante.

2. Procédé selon la revendication 1, dans lequel l'échangeur de chaleur combiné air-fluide de refroidissement et l'évaporateur (6), dans le cas où la puissance de refroidissement de l'échangeur de chaleur air-fluide de refroidissement n'est pas suffisante pour maintenir une température de l'air à l'intérieur de l'armoire de commande (20) à une température cible prédéterminée, l'échangeur de chaleur air-fluide de refroidissement et évaporateur (6) combiné fonctionne en alternance en tant qu'échangeur de chaleur air-fluide de refroidissement ou en tant qu'évaporateur, l'échangeur de chaleur air-fluide de refroidissement et évaporateur (6) combiné passe du fonctionnement en tant qu'évaporateur en un fonctionnement en tant qu'échangeur de chaleur air-fluide de refroidissement lorsque la température de l'air à l'intérieur de l'armoire de commande (20) atteint une valeur limite inférieure qui se trouve en dessous de la température cible et l'échangeur de chaleur combiné air-fluide de refroidissement et l'évaporateur (6) passe du fonctionnement en tant qu'échangeur de chaleur air-fluide de refroidissement en un fonctionnement en tant qu'évaporateur lorsque la température de l'air à l'intérieur de l'armoire de commande (20) atteint une valeur limite supérieure qui se trouve au-dessus de la température cible.

3. Procédé selon l'une des revendications 1 ou 2, dans lequel la puissance de refroidissement de l'échangeur de chaleur air-fluide de refroidissement est régulée par l'intermédiaire d'une vitesse de rotation d'une pompe qui fait circuler le fluide de refroidissement et/ou une vitesse de rotation d'un ventilateur d'un autre échangeur de chaleur air-fluide de refroidissement (12) entre lequel et l'échangeur de chaleur air-refroidissement de l'échangeur de chaleur air-refroidissement et évaporateur combiné, le fluide de refroidissement circule, et dans lequel la puissance de refroidissement de l'évaporateur est régulée par l'intermédiaire de la vitesse de rotation d'un compresseur du circuit de refroidissement actionné par compresseur.

4. Appareil de refroidissement (1) pour une armoire de commande (20), avec un boîtier (2), qui comprend un premier passage d'air (3) avec une première ouverture d'entrée d'air (4) et une première ouverture de sortie d'air (5), moyennant quoi, dans le premier passage d'air (3) se trouve un échangeur de chaleur air-air (7) et avec un deuxième passage (8), qui est réalisé entre une deuxième ouverture d'entrée d'air (9) et une deuxième ouverture de sortie d'air (10), moyennant quoi l'échangeur de chaleur air-air (7) est disposé en outre dans le deuxième passage d'air (8), moyennant quoi la première ouverture d'entrée d'air (4) et la première ouverture de sortie d'air (5) sont ouvertes vers l'environnement de l'armoire de commande (20) et la deuxième ouverture d'entrée d'air (9) ainsi que la deuxième ouverture de sortie d'air (10) sont ouvertes vers l'intérieur de l'armoire de commande (20), et moyennant quoi le premier passage d'air (3) étant séparée de manière fluidique du deuxième passage d'air (8),
**caractérisé en ce que**, dans la direction d'écoulement de l'air (x) derrière l'échangeur de chaleur air-air (7), se trouve un échangeur de chaleur air-fluide de refroidissement et évaporateur (6) combiné qui fonctionne au choix en tant qu'échangeur de chaleur air-fluide de refroidissement ou en tant qu'évaporateur (6), est disposé dans le deuxième passage d'air (8), qui fait partie d'un circuit de refroidissement actionné par compresseur ou basé sur la circulation d'un fluide de refroidissement, qui comprend en outre un échangeur de chaleur air-fluide de refroidissement et un condenseur (11), qui correspond, à l'extérieur du boîtier (2), à un réservoir de chaleur différent de l'échangeur de chaleur air-fluide de refroidissement et évaporateur (6) combiné, de façon à ce que l'échangeur de chaleur air-fluide de refroidissement et évaporateur combiné (6) fonctionne en tant qu'échangeur de chaleur air-fluide de refroidissement lorsqu'un post-refroidissement, créé par l'échangeur de chaleur air-fluide de refroidissement, de l'air guidé par le deuxième passage d'air (8) à travers l'échangeur de chaleur air-air (7) suffit, dans le cas d'une puissance de perte donnée d'une source de chaleur à l'intérieur de l'armoire de commande (20), pour obtenir un refroidissement suffisant de l'air guidé par le deuxième passage d'air (8) et de façon à ce que l'échangeur de chaleur air-fluide de refroidissement et évaporateur (6) combiné fonctionne en tant qu'évaporateur d'un circuit de refroidissement actionné par compresseur lorsque la puissance de refroidissement, générée par le fonctionnement de l'échangeur de chaleur air-fluide de refroidissement et évaporateur (6) combiné en tant qu'échangeur de chaleur air-fluide de refroidissement n'est pas suffisante.

5. Appareil de refroidissement (1) selon la revendication 4, dans lequel l'échangeur de chaleur air-air (7) est disposé en outre dans un passage entre le premier et le deuxième passage (3, 8).

6. Appareil de refroidissement (1) selon la revendication 4 ou 5, dans lequel l'échangeur de chaleur air-air (7) sépare le premier passage d'air (3) du deuxième passage d'air (8) de manière fluidique, le premier et le deuxième passage d'air (3, 8) étant couplés thermiquement pour l'échange de chaleur par l'intermédiaire de l'échangeur de chaleur air-air (7).

7. Appareil de refroidissement (1) selon l'une des revendications 4 à 6, dans lequel l'appareil de refroidissement (1) est monté sur un côté extérieur (21) de l'armoire de commande (20), le premier passage (3) étant disposée à l'extérieur de l'armoire de commande (20) et le deuxième passage d'air (8) étant disposé à l'intérieur de l'armoire de commande (20).

8. Appareil de refroidissement (1) selon la revendication 4, dans lequel l'armoire de commande (20) est installée à l'intérieur d'un bâtiment, le générateur d'eau froide (11) étant disposé à l'extérieur du bâtiment.
